# EUROPEAN PATENT SPECIFICATION

(11) **EP 2 221 913 B1**
(45) Date of publication and mention of the grant of the patent: **09.01.2013**
(21) Application number: 08859621.8
(22) Date of filing: 27.11.2008
(51) Int. Cl.: H01Q 1/24, H01Q 21/30, H04M 1/02, H01Q 1/52, H01Q 21/28

(54) **FOLDABLE PORTABLE TERMINAL**
ZUSAMMENFALT- UND TRAGBARES ENDGERÄT
TERMINAL PORTABLE PLIANT

(30) Priority: 12.12.2007 JP 2007320792
(43) Date of publication of application: 25.08.2010
(73) Proprietor: NEC Corporation, Minato-ku Tokyo 108-8001 (JP)
(72) Inventor: KOJIMA, Takuya, Tokyo 108-8001 (JP)
(74) Representative: Glawe, Delfs, Moll
(86) International application number: PCT/JP2008/071587
(87) International publication number: WO 2009/075193

(56) References cited:
- WO-A1-2007/024409
- JP-A- 2005 057 664
- JP-A- 2006 067 133
- JP-A- 2007 288 561
- US-A1- 2003 146 873

## Description

### [Technical Field]

The present invention relates to a folded-type mobile terminal.

### [Background Art]

Recent mobile phones include some models equipped with a receiving function of terrestrial digital television broadcasting. A whip antenna is often used as antenna for terrestrial digital televisions of these mobile phones. In this case, in order to view the terrestrial digital television broadcasting, on each time, users have to project the whip antenna, and to store the antenna after the viewing, and feel it inconvenient. In addition, since degree of freedom of design is limited because the whip antenna goes out from a case, it is requested to equip a built-in type receiving antenna for the terrestrial digital television broadcasting.

For example, it has been known that combination of a GND (ground) pattern of an upper printed wiring board of an upper housing and a GND pattern of a lower printed wiring board of a lower housing as a radiating element is employed as a dipole antenna so that built-in antenna is realized for accommodating and receiving terrestrial digital television broadcasting.

Some of folded-type mobile phones relating to the present invention have a first antenna mounted on a lower housing hinge part, and a second antenna consisting of the upper printed wiring board and the lower printed wiring board as a dipole antenna (hereinafter, housing dipole antenna).

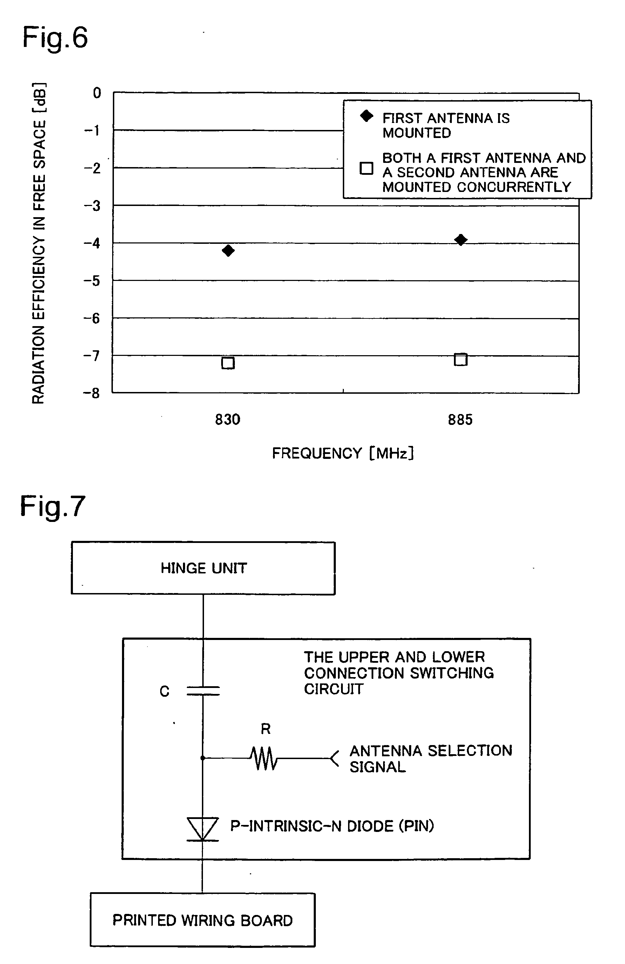

Fig. 6 explains the result of comparison of the following antenna characteristics: one is with the first antenna and the second antenna used concurrently and the other is with only the first antenna used. In Fig. 6, horizontal axis indicates frequency and vertical axis indicates radiation efficiency in free space. In this case, it indicates the antenna characteristic of the first antenna at 800MHz band and when the upper housing and the lower housing are open position. As shown in Fig. 6, when the first antenna and the second antenna are used concurrently, it is known that the antenna characteristic of the first antenna degrades from -4dB to -7dB approximately. The degradation of the antenna characteristics of the first antenna is justified by a deviation occurred on a current distribution on the printed wiring boards by connecting the upper printed wiring board and the lower printed wiring board in order to activate the second antenna.

In order to prevent degradation of the antenna characteristics of the first antenna even when the second antenna is mounted, as shown in Fig. 7, a method of switching the connection between the upper part and the lower part can be considered. Fig. 7 is a figure showing an example of the upper and lower connection switching circuit which switches the state of the connection between the upper printed wiring board and the lower printed wiring board. In the switching method of the upper and lower connection using the upper and lower connection switching circuit shown in Fig. 7 the upper and lower connection switching circuit is set up in a joint part of the upper printed wiring board and the lower printed wiring board. And a PIN (P-type-intrinsic-N-type) diode is turned off at a time when the first antenna is used so that the connection between the upper printed wiring board and the lower printed wiring board is cut off. The PIN diode is turned on at a time when the second antenna (i.e. housing dipole antenna) is used. An antenna selection signal controls on and off of the PIN diode as above mentioned so that the lower printed wiring board and the upper printed wiring board are connected. As a result, it can secure sufficient characteristics for both antennas.

Some examples of the antenna switching technologies are disclosed in patent documents 1-3. In patent document 1 disclosed an antenna control method, in which plural antennas covering different frequency band are equipped. And, when communicating by using a predetermined frequency band among frequency bands, a transmitting system uses only an antenna corresponding to the frequency band and a receiving system uses a synthetic diversity of an antenna corresponding to the frequency band and other antenna.

The antenna control method uses a first antenna, a transmission/reception circuit for 800MHz band, a second antenna and a transmission/reception circuit for 2GHz band. When communicating by using CDMA(Code Division Multiple Access)2000 1xEV-DO(EVolution Data Only(CDMA 2000 1xEV-DO: hereinafter referred to as EV-DO)) at 800MHz band, changing each switch, it uses the first antenna as a main antenna for the transmission/reception and the second antenna as a sub-antenna only for the reception. There is no reduction of gain of the first antenna which is the main antenna since it is for 800MHz, and the second antenna is less sensitive to signals at 800MHz since it is for 2GHz. However, it is possible to expect effects of the diversity since the sub-antenna is available. When communicating by using EV-DO at 2GHz band, it is supposed to use the second antenna as the main antenna and use the first antenna as the sub-antenna.

A portable wireless device of patent document 2 is equipped with a dipole antenna including two wiring boards, a feeding circuit which connects the two wiring boards and a radio circuit connected to the feeding circuit. In the portable wireless device, the wiring board is divided into at least two separated wiring boards in the antenna length direction and has electrically connecting and disconnecting means of connection and disconnection respectively between the separated wiring board on each the wiring board.

3 Two wiring boards of which the portable wireless device is composed operate as a radiating element of the dipole antenna, and it can realize wireless communications. Further, since each of the wiring boards is divided into not smaller than two wiring boards respectively in the longitudinal direction of the antenna and composed so that connections and disconnections of these wiring boards are possible, it is possible to change length of these wiring boards which is operated as the dipole antenna (i.e. total length of the antenna) by connecting or disconnecting these separated boards. Accordingly, it can use for at least two wireless communication frequencies, and it is able to improve conveniences, simplify configurations, and reduce restrictions with design of the portable wireless device.

A folded-type portable wireless device of patent document 3 has a freely opening and closing mechanism where a first housing and a second housing are connected at a hinge part and includes a third antenna element mounted in a lower part of the second housing and further includes a parasitic element which is positioned at a separating and opposing position along transverse direction from a third feeding part and is united with conductive radiation sheet and is connected with GND. An open end of the third antenna element connect with an open end of the parasitic element for realizing broadband operation. The folded-type portable wireless device includes the following function.

The disclosed folded-type portable wireless device can obtain broadband characteristics of the antenna which is mounted in lower part of the lower housing and can improve a characteristic at a standby mode (in particular, antenna gain on a metal plate) of the antenna which is mounted at lower part and upper part of the lower housing. Moreover, spaces for the antenna can be saved and a part of the antenna incorporates with other parts, so that thickness and overall size, along with production cost, can be reduced with the folded-type portable wireless device.
[The patent document 1] The Japanese Patent Application Laid-Open No. 2005-347791
[The patent document 2] The Japanese Patent Application Laid-Open No. 2007-74366
[The patent document 3] The Japanese Patent Application Laid-Open No. 2007-288561

A folded-type mobile terminal according to the preamble of claim 1 is disclosed in JP 2006-067133 A and a similar device is disclosed in JP 2007-288561 A.

The dependent claims are related to further developments of the invention.

### [Disclosure of Invention]

### [Technical Problem]

However, in a folded-type mobile phone with a television viewing function, when an antenna for communications is mounted in a hinge part and a dipole antenna for viewing television is mounted in a housing, a problem may arise that the antenna for communications and the antenna for televisions viewing cannot be concurrently used with the method shown in the above-mentioned Fig. 7. In addition, the device becomes complicated if the technologies described in the patent document 1-3 are applied to it. Accordingly, the object of the present invention is to provide a composition which is capable of securing the antenna characteristics both of an antenna used at a first frequency band and a housing dipole antenna used at a second frequency band with an easy structure.

### [Technical Solution]

The device of the present invention is defined in claim 1.

According to the invention an impedance element is inserted in the joint part of the upper printed wiring board and the lower printed wiring board, respectively, influence of the first frequency band is eliminated.

### [Advantageous Effect]

According to the present invention, it can be capable of securing the antenna characteristics both of an antenna used at a first frequency band and a housing dipole antenna used at a second frequency band with an easy structure.

### Brief Description of Drawings]

Fig. 1 is a figure showing composition of the dipole antenna used for the folded-type mobile phone according to the present invention.
Fig. 2 is a figure showing composition of an embodiment of the impedance element used for the folded-type mobile phone according to the present invention.
Fig. 3 is a Smith chart showing an example of the impedance of the impedance element which is shown in Fig. 2.
Fig. 4 is a configuration diagram showing another embodiment of the impedance element used for the folded-type mobile phone according to the present invention.
Fig. 5 is a Smith chart showing an example of impedance of the impedance element which is shown in Fig. 4.
Fig. 6 is an explanatory drawing comparing the antenna characteristic when the first antenna and the second antenna are used concurrently with that when only the first antenna is used at a time.
Fig. 7 is a figure showing an example of the upper and lower connection switching circuit which executes connection on and off between the upper printed wiring board and the lower printed wiring board.
Fig. 8 is a perspective diagram showing a composition of the folded-type mobile phone according to the present invention.
Fig. 9 is a figure showing a composition around the hinge part which is used for the folded-type mobile phone shown in Fig. 8.

### [Best Mode for Carrying out the Invention]

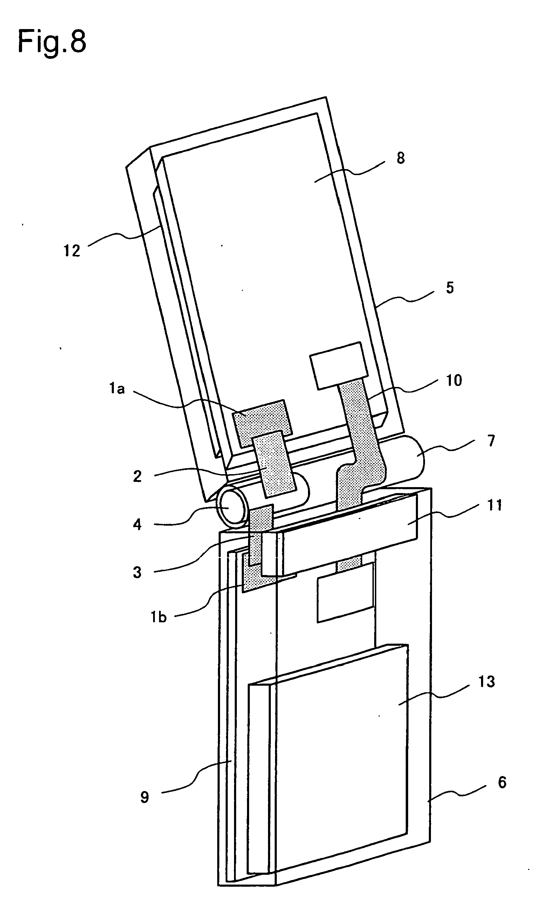

Hereinafter, embodiments of the present invention will be described in detail. Followings are descriptions of the embodiments of the present invention using drawings. In particular, the embodiments will describe in a case of folded-type mobile phones. Fig. 8 is a perspective diagram showing a composition of the folded-type mobile phone according to the present invention. The folded-type mobile phone which is shown in Fig. 8 includes an upper housing 5, a lower housing 6, a hinge part 7 having opening and closing mechanism wherein edge part is connected with both the upper housing 5 and the lower housing 6, an upper and lower printing wiring board joint part 10 comprising a flexible wiring board (ex. polyimide substrate), and an antenna 11 for a first frequency band which is arranged in neighborhood of the hinge part 7 on the lower housing 6. Further, the upper housing 5 contains an upper printed wiring board 8, a display part 12 and the like, the lower housing 6 contains a lower printed wiring board 9, a battery 13 and the like, and the hinge part 7 contains a hinge unit 4 made of conductive material (ex. stainless) and a support metal fittings, which is not shown in the diagram, capable of passing the joint part for the upper printed wiring boards 8 and the lower printed wiring boards 9.

In addition, the mobile phone has an upper joint metal fitting 2 (ex. silver plated copper sheet or stainless steel sheet) which connects the upper printed wiring board 8 and the hinge unit 4, and a lower joint metal fitting 3 (ex. silver plated copper sheet or stainless steel sheet) which connects the lower printed wiring board 9 and the hinge unit 4. Further, the mobile phone has a communications function using WCDMA (Wideband Code Division Multiple Access) and a viewing function of terrestrial digital television broadcasting, and it is supposed that frequency of 2GHz band (ex. 1, 920MHz-2, 170MHz) is allocated for the communications. Furthermore, for example, frequency of the terrestrial digital television broadcasting is allocated at 470MHz-770MHz.

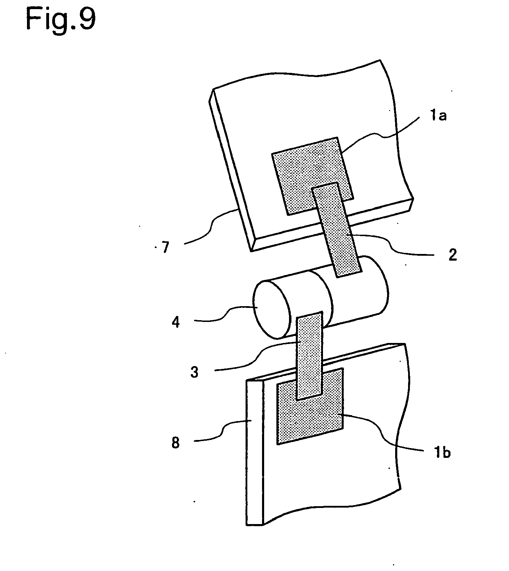

Fig. 9 is a figure which indicating a composition around the hinge part which is used for the folded-type mobile phone that is shown in Fig. 8. An impedance element 1a is arranged between the upper joint metal fitting 2 and the upper printed wiring board 8, and an impedance element 1b is arranged between the lower joint metal fitting 3 and the lower printed wiring board 9, respectively. A dipole antenna is configured by connecting the upper printed wiring board 8 and the lower printed wiring board 9 through the pair of metal fittings 2 and 3 (top position and bottom position in Fig. 8) and the hinge unit 4.

In particular, it is important to arrange the impedance elements 1a and 1b at the upper and lower joint part (i.e. the joint part of the upper printed wiring board 8 and the lower printed wiring board 9) respectively. This is because, by keeping the hinge unit 4 in a floating status so as the hinge unit 4 does not contact directly with the upper printed wiring board 8 and the lower printed wiring board 9, hinge unit 4 is not considered as a GND (i.e. apparent impedance of sum of the upper joint metal fitting 2, the lower joint metal fitting 3 and the hinge part 7 is larger than the impedance of a continuous plate consisting of the upper joint metal fitting 2 and the lower joint metal fitting 3). Thus, it can realize the same condition as a case where the housing dipole antenna is not composed.

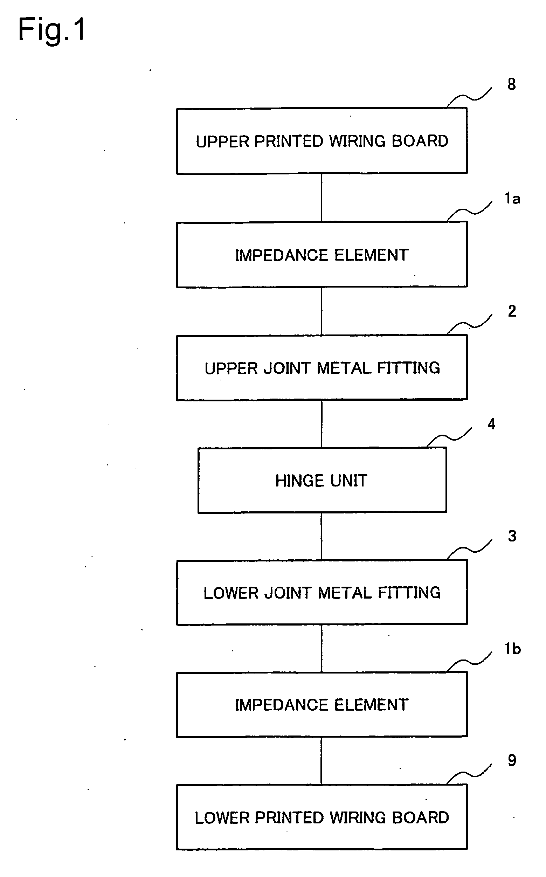

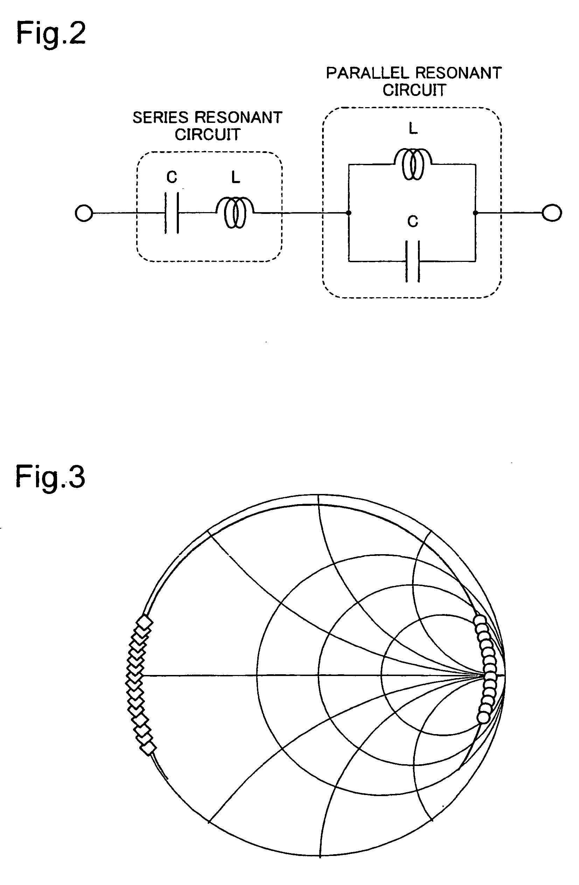

Followings are descriptions of functions of the impedance elements. Fig. 1 is a figure showing a composition of the dipole antenna used for the folded-type mobile phone according to the present invention, and Fig. 2, is a figure showing a composition of an embodiment of the impedance element used for the folded-type mobile phone according to the present invention. The impedance element 1a and 1b comprise resonant circuit which is a combination of a series resonant circuit and a parallel resonant circuit using chip capacitors and chip coils. By adjusting resonant frequency of the series resonant circuit to the frequency of the terrestrial digital television broadcasting, since impedance at frequency of the terrestrial digital television broadcasting becomes low, it can keep connected status between the upper printed wiring board 8 and the lower printed wiring board 9 at the high frequency signals. Thus, it activates the housing dipole antenna by a combination of the upper printed wiring board 8 and the lower printed wiring board 9.

By adjusting resonant frequency of the parallel resonant circuit to 2GHz band, since impedance at frequency for the communications becomes high, it can keep the non-connection status of the upper printed wiring board 8 and the lower printed wiring board 9 at the high frequency signals.

Fig. 3 is a Smith chart showing an example of impedance of the impedance element which is shown in Fig. 2. In the chart, the impedance locus is a calculated value from 400MHz to 2,300MHz, and a range indicated by rhombic marks is a frequency band allocated for the terrestrial digital television broadcasting (i.e. 470MHz-770MHz) and range indicated by round marks is a frequency band allocated for the WCDMA (i.e. 2GHz band: 1,920MHz-2,170MHz). According to Fig. 3, the rhombic marks are adjusted around SHORT in the Smith chart and it is understood that the impedance becomes low, and the round marks are adjusted around OPEN in the Smith chart and it is understood that the impedance becomes high. This means that, at the high frequency signals, it is conductive at the frequency using for the terrestrial digital television broadcasting frequency band, and is non-conductive at the frequency of 2GHz band using for the WCDMA.

In this way, by arranging the impedance elements 1a and 1b between the metal fittings 2 and 3 and the printed wiring boards 8 and 9 respectively, it can secure antenna characteristics of both the antenna mounted on the hinge part and the housing dipole antenna together.

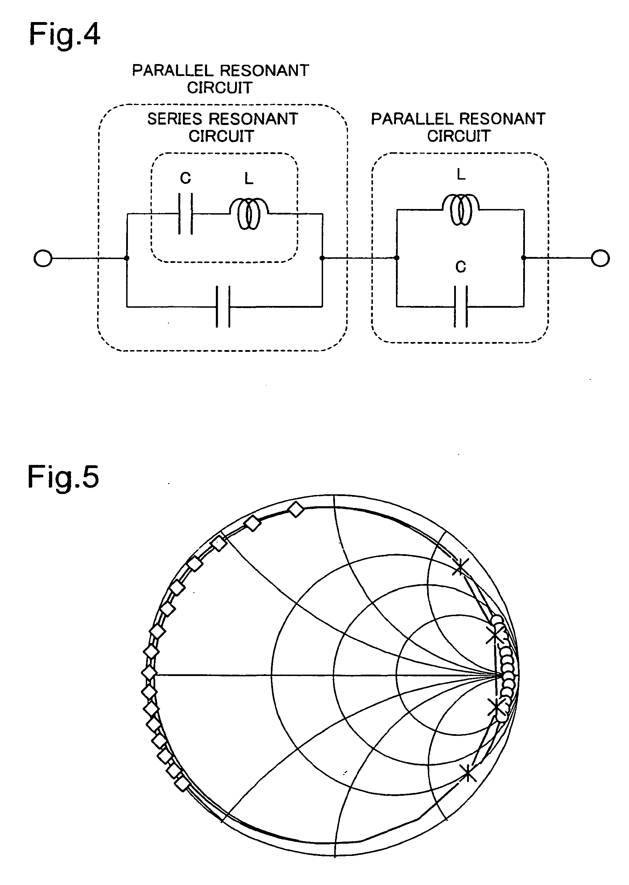

Fig. 4 is a configuration diagram showing another embodiment of the impedance element applied to the folded-type mobile phone according to the present invention. As shown in Fig. 4, according to the second embodiment, the antenna for communications assumes that it operates at two frequency bands; i.e. 2GHz band (1920MHz-2170MHz) and 800MHz band (830MHz-885MHz). Other components of the mobile phone have the same configuration as the first embodiment described in Fig. 8 and Fig. 9, The impedance element described in the second embodiment is composed of a resonant circuit which is a combination of the series resonant circuit and two parallel resonant circuits. The resonant frequency of the series resonant circuit is adjusted to the bandwidth of the terrestrial digital television broadcasting. The parallel resonant circuit is a parallel combination of the series resonant circuit and capacitors and the resonant frequency is adjusted to 800MHz band. Resonant frequency of the other parallel resonant circuit is adjusted to 2GHz band.

Fig. 5 is a Smith chart showing an example of impedance of the impedance element which is shown in Fig. 4. The impedance locus which is shown in Fig. 5 is a calculated value from 400MHz to 2,300MHz, and the range indicated by rhombic marks is 470MHz-770MHz frequency band which is allocated for the terrestrial digital television broadcasting, the range indicated by round marks is 2GHz band (1,920MHz-2,170MHz) which is allocated for the WCDMA, and the range indicated by X marks indicates 800MHz band (830MHz-885MHz) which is allocated for the WCDMA. According to Fig. 5, the rhombic marks are adjusted around SHORT of the Smith chart and this means that the impedance becomes low, and the round marks and the X marks are adjusted around OPEN of the Smith chart and this means that the impedance becomes high. This means that, at the high frequency signals, it is conductive at the band that is allocated for the terrestrial digital television broadcasting, and is non-conductive at the 2GHz band and the 800MHz band that are allocated for the WCDMA.

In this way, by arranging the impedance elements 1a and 1b between the metal fittings 2 and 3 and the printed wiring boards 8 and 9 respectively, it can secure antenna characteristics of both the antenna mounted on the hinge part 4 and the housing dipole antenna together. Further, although it is described that the impedance of the impedance elements is adjusted to high at the band of the antenna of communications and the impedance of the impedance elements is adjusted to low at the band of the housing dipole antenna, it is not always adjusted as the described manner. Composition of the impedance elements needs to be appropriately adjusted considering factors such as mounting conditions of the parts of the mobile phone, arrangement of the antennas, upper and lower connection methods for configuring the housing dipole antenna, and mounting position of the impedance elements. It is important to adjust the impedance of the impedance elements so as the housing dipole antenna does not degrade the performance of the antenna for the communications.

### (The effect of the Invention)

The folded-type mobile phone includes a first antenna which is used at a first frequency band and a second antenna consisting of a dipole antenna which is composed of an upper printed wiring board and a lower printed wiring board that are connected by a conductive hinge part and is used at a second frequency band. In the folded-type mobile phone, the impedance element which eliminates influence to the first frequency band is inserted at a joint part between the upper printed wiring board and the lower printed wiring board, and resonant frequency of series resonant circuit of the impedance element is adjusted to the second frequency, so that impedance of the impedance element becomes low at the second frequency. Thus, the upper printed wiring board and the lower printed wiring board can be put in an electrically connected status at the high frequency signals. In this manner, it can activate the housing dipole antenna using the upper printed wiring board and the lower printed wiring board. In addition, by adjusting the resonant frequency of a parallel resonant circuit of the impedance element to the second frequency band, it is possible that the upper printed wiring board and the lower printed wiring board are virtually disconnected at the first frequency band, because the impedance of the impedance element becomes high. As the result, it can secure together antenna characteristics of both the antenna used at the first frequency band and the housing dipole antenna used at the second frequency band by an easy structure.

Further, the embodiment mentioned above indicating an example of preferred embodiment of the present invention, and the present invention will not only apply to the stated embodiment, but also apply to various transformed implementations within the scope of not deviating from the invention. For example, it is possible to apply the present invention to folded-type PDA (Personal Digital Assistants). Further, the impedance element may be connected to earth patterns of the upper printed wiring board and the lower printed wiring board respectively.

Also, the impedance element may comprise a series connection of series resonant circuit and parallel resonant circuit.

In addition, the impedance element may comprise a series connection of parallel resonant circuit and parallel resonant circuit.

Further, the impedance element arranged on the upper printed wiring board and the hinge part may be connected by metal fitting. Furthermore, the impedance element arranged on the lower printed wiring board and the hinge part may be connected by metal fitting.

Also, the series resonant circuit and the parallel resonant circuit may comprise chip capacitor and chip coil.

### [Explanation of Reference]

- 1a and 1b:: impedance element
- 2:: upper joint metal fitting
- 3:: lower joint metal fitting
- 4:: hinge unit
- 5:: upper housing
- 6:: lower housing
- 7:: hinge part
- 8:: upper printed wiring board
- 9:: lower printed wiring board
- 10:: board connecting upper printed wiring board and lower printed wiring board
- 11:: antenna
- 12:: display part
- 13:: battery

## Claims

1. A folded-type mobile terminal, comprising:
an upper housing (5) which accommodates an upper printed wiring board (8);
a lower housing (6) which connects with the upper housing (5) by a hinge part (7, 4) and accommodates a lower printed wiring board (9);
a first antenna (11) used at a first frequency band; and
a second antenna which is used at a second frequency band different from the first frequency band and is a dipole antenna including a combination of the upper printed wiring board (8) and the lower printed wiring board (9) via the hinge part (4); and
**characterized in that** an impedance element (1a) is inserted between the upper printed wiring board (8) and the hinge part (4) and another importance element (1b) between the lower printed wiring board (9) and the hinge part (4), wherein said impedance elements (1a, 1b) become high impedance at the first frequency band to eliminate influence to the first frequency band, and low impedance at the second frequency band.

2. The folded-type mobile terminal according to claim 1, wherein the impedance elements (1a, 1b) are connected to earth pattern of the upper printed wiring board (8) and earth pattern of the lower printed wiring board (9), respectively.

3. The folded-type mobile terminal according to claim 2, wherein the impedance elements (1a, 1b) include a circuit which is configured by connecting serially a series resonant circuit and a parallel resonant circuit.

4. The folded-type mobile terminal according to claim 2, wherein the impedance elements (1a, 1b) include a circuit which is configured by connecting serially a parallel resonant circuit and a parallel resonant circuit.

5. The folded-type mobile terminal according to claim 3 or claim 4, wherein a metal fitting (2, 3) connects the impedance element (1a) in the upper printed wiring board side with the hinge part (4) and connects the impedance element (1b) in the lower printed wiring board side with the hinge part (4).

6. The folded-type mobile terminal according to claim 4, wherein the parallel resonant circuit include a chip capacitor and a chip coil.

7. The folded-type mobile terminal according to claim 3, wherein the series resonant circuit and the parallel resonant circuit include a chip capacitor and a chip coil.

## Patentansprüche

1. Mobilendgerät in Klappenbauart mit:
einem oberen Gehäuse (5), das eine obere gedruckte Schaltungskarte (8) aufnimmt,
einem unteren Gehäuse (6), das mit dem oberen Gehäuse (5) über einen Schanierteil (7, 4) verbunden ist und eine untere gedruckte Schaltungskarte (9) aufnimmt,
einer erste Antenne (11), die in einem ersten Frequenzband verwendet wird, und
einer zweiten Antenne, die in einem zweiten Frequenzband, das sich von dem ersten Frequenzband unterscheidet, verwendet wird und einschließlich einer Kombination der oberen gedruckten Schaltungskarte (8) und der unteren gedruckten Schaltungskarte (9) über den Schanierteil (4) eine Dipolantenne ist, und
**dadurch gekennzeichnet, dass** ein Impedanzelement (1a) zwischen die obere gedruckte Schaltungskarte (8) und den Schanierteil (4) und ein weiteres Impedanzelement (1b) zwischen der unteren gedruckten Schaltungskarte (9) und den Schanierteil (4) eingefügt ist, wobei die Impedanzelemente (1a, 1b) bei einem ersten Frequenzband zu einer hohen Impedanz werden, um den Einfluss auf das erste Frequenzband zu eliminieren, und bei dem zweiten Frequenzband zu einer niedrigen Impedanz werden.

2. Mobiles Endgerät in Klappenbauart nach Anspruch 1, wobei die Impedanzelemente (1a, 1b) mit Massenmustern der oberen gedruckten Schaltungskarte (8) beziehungsweise Massenmustern der unteren gedruckten Schaltungskarte (9) verbunden sind.

3. Mobiles Endgerät in Klappenbauart nach Anspruch 2, wobei die Impedanzelemente (1a, 1b) eine Schaltung umfassen, die durch serielle Verbindung einer Reihenresonanzschaltung und einer Parallelresonanzschaltung gebildet ist.

4. Mobiles Endgerät in Klappenbauart nach Anspruch 2, wobei die Impedanzelemente (1a, 1b) eine Schaltung aufweisen, die durch serielle Verbindung einer parallelen Resonanzschaltung und einer parallelen Resonanzschaltung gebildet ist.

5. Mobiles Endgerät in Klappenbauart nach Anspruch 3 oder Anspruch 4, wobei ein Metallbauteil (2, 3) die Impedanzelemente (1a) in der oberen gedruckten Schaltungskartenseite mit dem Schanierteil (4) verbindet und das Impedanzelement (1b) in der unteren gedruckten Schaltungskarte mit dem Schanierteil (4) verbindet.

6. Mobiles Endgerät in Klappenbauart nach Anspruch 4, wobei die parallele Resonanzschaltung einen Chipkondensator und eine Chipspule aufweist.

7. Mobiles Endgerät in Klappbauart nach Anspruch 3, wobei die Reihenresonanzschaltung und die parallele Resonanzschaltung einen Chipkondensator und eine Chipspule aufweisen.

## Revendications

1. Terminal mobile de type plié, comprenant :
un logement supérieur (5) qui accueille une carte de circuit imprimé supérieure (8) ;
un logement inférieur (6) qui se connecte avec le logement supérieur (5) par une partie de charnière (7, 4) et accueille une carte de circuit imprimé inférieure (9) ;
une première antenne (11) utilisée à une première bande de fréquences ; et
une seconde antenne qui est utilisée à une seconde bande de fréquences différente de la première bande de fréquences et est une antenne dipôle incluant une combinaison de la carte de circuit imprimé supérieure (8) et de la carte de circuit imprimé inférieure (9) via la partie de charnière (4) ; et
**caractérisé en ce qu'**un élément d'impédance (la) est inséré entre la carte de circuit imprimé supérieure (8) et la partie de charnière (4) et un autre élément d'impédance (1b) entre la carte de circuit imprimé inférieure (9) et la partie de charnière (4), dans lequel lesdits éléments d'impédance (la, 1b) deviennent de haute impédance à la première bande de fréquences pour éliminer l'influence sur la première bande de fréquences, et de basse impédance à la seconde bande de fréquences.

2. Terminal mobile de type plié selon la revendication 1, dans lequel les éléments d'impédance (la, 1b) sont connectés à un motif de terre de la carte de circuit imprimé supérieure (8) et à un motif de terre de la carte de circuit imprimé inférieure (9), respectivement.

3. Terminal mobile de type plié selon la revendication 2, dans lequel les éléments d'impédance (1a, 1b) incluent un circuit qui est configuré en connectant en série un circuit résonnant série et un circuit résonnant parallèle.

4. Terminal mobile de type plié selon la revendication 2, dans lequel les éléments d'impédance (1a, 1b) incluent un circuit qui est configuré en connectant en série un circuit résonnant parallèle et un circuit résonnant parallèle.

5. Terminal mobile de type plié selon la revendication 3 ou la revendication 4, dans lequel une pièce en métal (2, 3) connecte l'élément d'impédance (1a) du côté carte de circuit imprimé supérieure avec la partie de charnière (4) et connecte l'élément d'impédance (1b) du côté carte de circuit imprimé inférieure avec la partie de charnière (4).

6. Terminal mobile de type plié selon la revendication 4, dans lequel le circuit résonant parallèle inclut un condensateur miniature et une bobine miniature.

7. Terminal mobile de type plié selon la revendication 3, dans lequel le circuit résonant série et le circuit résonant parallèle incluent un condensateur miniature et une bobine miniature.
